(19) **Europäisches Patentamt / European Patent Office / Office européen des brevets**

(11) **EP 2 668 719 B1**

(12) **FASCICULE DE BREVET EUROPEEN**

(45) Date de publication et mention de la délivrance du brevet:
**17.07.2019 Bulletin 2019/29**

(21) Numéro de dépôt: **12705376.7**

(22) Date de dépôt: **25.01.2012**

(51) Int Cl.:
**H03H 11/04** *(2006.01)*     **H03H 17/00** *(2006.01)*
**H03H 11/12** *(2006.01)*     **H04B 3/54** *(2006.01)*
**H04L 27/00** *(2006.01)*

(86) Numéro de dépôt international:
**PCT/FR2012/050162**

(87) Numéro de publication internationale:
**WO 2012/101382 (02.08.2012 Gazette 2012/31)**

(54) **FILTRE DE PONDÉRATION, PROCÉDÉS ET DISPOSITIFS D'ÉMISSION ET DE RÉCEPTION D'UN SIGNAL ANALOGIQUE ET PROGRAMME D'ORDINATEUR CORRESPONDANTS**

GEWICHTUNGSFILTER SOWIE ENTSPRECHENDE VERFAHREN UND VORRICHTUNGEN ZUM SENDEN UND EMPFANGEN EINES ANALOGSIGNALS UND COMPUTERPROGRAMM DAFÜR

WEIGHTING FILTER, AND CORRESPONDING METHODS AND DEVICES FOR TRANSMITTING AND RECEIVING AN ANALOG SIGNAL AND COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.01.2011 FR 1150575**

(43) Date de publication de la demande:
**04.12.2013 Bulletin 2013/49**

(73) Titulaire: **Orange**
**75015 Paris (FR)**

(72) Inventeurs:
• **LANOISELEE, Marc**
  **35200 Rennes (FR)**
• **SIOHAN, Pierre**
  **35200 Rennes (FR)**

(74) Mandataire: **Vidon Brevets & Stratégie**
**16B, rue de Jouanet**
**BP 90333**
**35703 Rennes Cedex 7 (FR)**

(56) Documents cités:
**WO-A1-2009/150224     US-A1- 2007 110 198**
**US-A1- 2011 194 626     US-B1- 6 819 706**

• **DENNIS BOHN: "Audio handbook", 1 janvier 1976 (1976-01-01), 19760101, PAGE(S) 1 - 5, XP007919549, alinéa [5.2.4]; figures 5.2.8,5.2.9**
• **J. R. ASHLEY & AL.: "Active and Passive Filters as Loudspeaker Crossover Networks", JOURNAL OF THE AUDIO ENGINEERING SOCIETY, vol. 19, no. 6, 12 septembre 1970 (1970-09-12), pages 494-502, XP002660914, New York**
• **Kerry Lacanette: "High-Performance Audio Applications of the LM833", National Semiconductors application note , 1 août 1985 (1985-08-01), XP002660915, Extrait de l'Internet: URL:http://www.national.com/an/AN/AN-346.p df#page=1 [extrait le 2011-10-07]**
• **J. R. ASHLEY & al.: "Operational amplifier Implementations of Ideal Electronic Crossover Networks", 38th Convention of the Audio Engineering Society Journal of the Engineering Society, 7 mai 1970 (1970-05-07), page 19PP, XP002660916, New York Extrait de l'Internet: URL:http://www.aes.org/tmpFiles/elib/20111 007/1287.pdf [extrait le 2011-10-07]**

EP 2 668 719 B1

**Description**

## 1. Domaine de l'invention

Le domaine de l'invention est celui des transmissions en analogique intervenant dans des systèmes de communication.

L'invention concerne notamment les interfaces analogiques d'entrée des émetteurs et/ou récepteurs d'un système de communication (en anglais « AFE transceiver » pour « Analog Front End transceiver »).

L'invention trouve notamment des applications dans le domaine des communications par courants porteurs en ligne (en anglais PLC pour « Power Line Communication »), en particulier pour la transmission de signaux dans une bande de fréquence « élargie » (de l'ordre de 0 à 500 MHz).

## 2. Art antérieur

*2.1 Transmission par courants porteurs en ligne*

La technologie des courants porteurs en ligne, telle que définie dans la spécification « HomePlug AV » ou dans le document « Recent Developments in the Standardization of Power Line Communications within the IEEE » de Stefano Galli et Oleg Logvinov, IEEE Communications Magazine, Juillet 2008, permet de créer un réseau local haut débit avec un réseau électrique existant.

Actuellement, cette technologie permet des transmissions haut débit dans une bande de fréquence de l'ordre de 0 à 30 MHz en utilisant une modulation de type OFDM.

Afin d'augmenter les débits de transmission pour atteindre des débits de l'ordre du gigabit par seconde, il est envisagé d'élargir la bande de fréquence jusqu'à des valeurs de l'ordre de 500 MHz.

Toutefois, plus cette bande de transmission est large, plus les risques d'interférence avec d'autres signaux sont élevés. Ainsi, afin de limiter les perturbations potentielles occasionnées par rayonnement des câbles secteur et affectant des systèmes radio situés dans les mêmes bandes de fréquence, un profil spécifique de puissance doit être respecté.

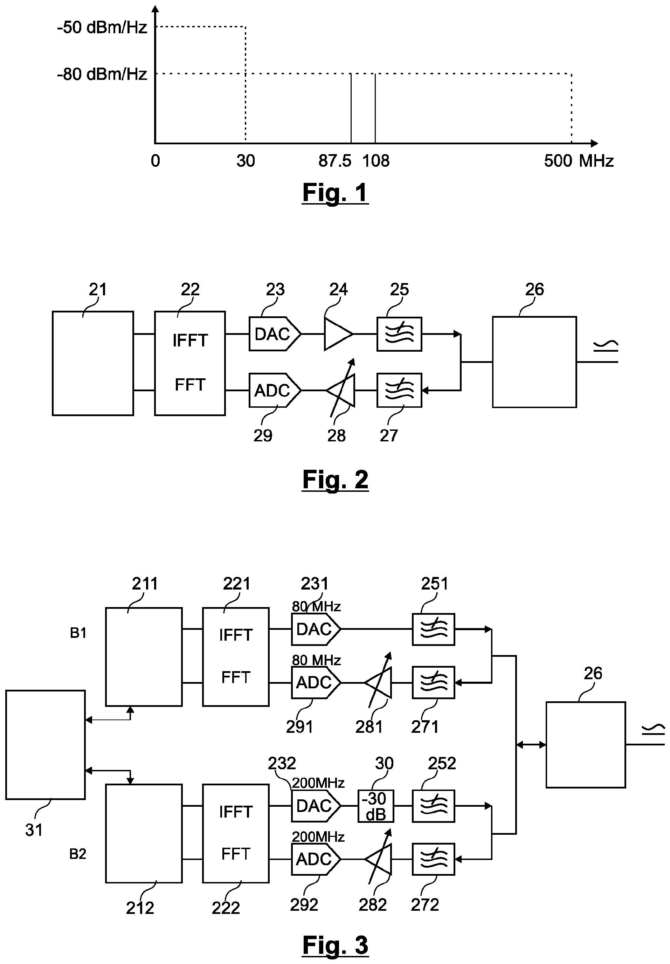

Un tel profil, tel qu'illustré en figure 1, prévoit que la densité maximale de puissance sur la bande de fréquence 0-30 MHz (encore appelée bande basse ou première bande) soit fixée à -50 dBm/Hz, et que la densité maximale de puissance sur la bande de fréquence 30-500 MHz (encore appelée bande haute ou deuxième bande) soit fixée à -80 dBm/Hz, soit 30 dB en dessous de la densité spectrale de puissance permise sur la première bande.

Une autre contrainte pour cet élargissement de bande est la présence de la bande FM entre 87,5 et 108 MHz, et des services de télédiffusion terrestre en VHF et UHF, dont les signaux sont à des niveaux de puissance relatifs très élevés et rendent ces portions de bande difficilement exploitables pour les signaux PLC.

Cet écart de niveau de 30 dB dans le profil de puissance, ainsi que la présence de la bande FM et des signaux de télédiffusion, constituent des difficultés techniques fortes pour la réalisation de la partie analogique d'un émetteur/récepteur (AFE) d'un système de communication, qui doit concilier à la fois grande dynamique et large bande passante.

Il est notamment connu du document WO2009/150224 (« Power line communication system », GIGLE SEMICONDUCTORS LIMITED) un système de communication PLC utilisant une pluralité de sous-bandes supportant des densités spectrales de puissance différentes. En particulier, ce document propose de réduire la densité spectrale de puissance dans la sous-bande supportant la plus forte densité spectrale de puissance, de façon à améliorer le rapport signal à bruit dans les sous-bandes supportant une densité spectrale de puissance plus faible et optimiser le débit dans le système.

*2.2 Emetteur/récepteur pour une transmission sur la bande 0-30 MHz*

La figure 2 illustre plus précisément le schéma de principe d'un système AFE, tel qu'utilisé actuellement pour la transmission de signaux PLC dans la bande 0-30 MHz.

Un tel système AFE comprend :

- un module de traitement numérique 21 au niveau couche physique ;
- un module de conversion fréquence/temps (IFFT pour « Inverse Fast Fourier Transform ») ou temps/fréquence (FFT) 22 ;
- un module de conversion numérique/analogique (DAC) 23 du signal numérique ;
- un module d'amplification 24 du signal analogique, alimentant un filtre d'émission 25 ;
- un module de couplage 26 au réseau secteur ;
- un filtre de réception 27 ;

- un module d'amplification à gain contrôlé (AGC) 28 du signal analogique issu du filtre de réception 27 ;
- un module de conversion analogique/numérique (ADC) 29 du signal analogique.

Plus précisément, en émission, le signal numérique issu du module de traitement numérique 21 est transformé du domaine fréquentiel vers le domaine temporel dans le module de conversion fréquence/temps 22, puis converti en analogique par le convertisseur numérique/analogique 23. Le signal analogique est ensuite amplifié 24 et filtré par le filtre d'émission 25, afin d'éliminer les composantes indésirables de la conversion numérique/analogique, puis couplé 26 au réseau secteur.

Un tel module de couplage 26 assure également la réception des signaux PLC.

Ainsi, en réception, le signal reçu est filtré par le filtre de réception 27 afin de ne conserver que les composantes utiles du spectre du signal, puis calibré en niveau de puissance par le module d'amplification à gain contrôlé 28, avant conversion analogique/numérique 29.

Avec cette structure, les performances du système AFE en termes de bande passante et de dynamique reposent essentiellement sur les caractéristiques des convertisseurs numérique/ analogique et analogique/numérique employés.

*2.3 Emetteur/récepteur pour une transmission sur la bande 0-500 MHz*

Toutefois, si l'on considère des transmissions sur une bande élargie de l'ordre de 0 à 500 MHz, il n'est actuellement pas possible de n'utiliser qu'un seul système AFE qui concilie l'ensemble des contraintes imposées.

En effet, si l'on se place dans la bande basse (jusqu'à 30 MHz), on considère que le rapport signal à bruit (SNR) est relativement bon du fait d'un niveau élevé de signal et de peu d'atténuation du canal. Il est donc souhaitable d'utiliser des convertisseurs numérique/analogique et analogique/numérique présentant un bon rapport signal à bruit, et donc un nombre de bit de quantification (en anglais ENOB pour « Effective Number Of Bit ») élevé. Ces caractéristiques permettent en effet d'atteindre de très bons débits de transmission avec des constellations à très grand nombre d'états, du type modulation d'amplitude en quadrature MAQ 1024 ou 4096 par exemple.

En revanche, si l'on se place dans la bande haute (entre 30 et 500 MHz) ces convertisseurs à ENOB élevé ne sont plus adaptés, car ils présentent des fréquences d'échantillonnage trop basses (de l'ordre de 300-400 MHz). De plus, l'atténuation de 30 dB du profil de puissance par rapport à la bande basse, ainsi que l'affaiblissement du canal de transmission, imposent de travailler avec de faibles rapports signal à bruit. Dans ces conditions, il est souhaitable d'employer d'autres types de convertisseurs qui n'ont que peu de bits de quantification, mais permettent d'échantillonner des signaux très large bande avec des fréquences d'échantillonnage de l'ordre du gigahertz.

Du fait de ces contraintes différentes entre bande basse et bande haute, les techniques proposées reposent sur une exploitation distincte de ces deux bandes, et sur la mise en oeuvre de deux types de couche physique et de systèmes AFE.

Par exemple, il est connu du document US2011/0194626 (« Multi-Wideband Communications Over Power Lines ») un système de communication PLC permettant à un noeud de recevoir simultanément et indépendamment des données transmises par courants porteurs en ligne par un premier noeud sur une première bande de fréquence et par un deuxième noeud sur une deuxième bande de fréquence.

En d'autres termes, il est actuellement envisagé de « dédoubler » le système AFE, comme illustré en figure 3, tel que chacune des deux bandes possède son propre traitement numérique couche physique qui doit être distinct (du moins en réception), en raison de conditions de traitement analogique, filtrage, AGC, et d'échantillonnage différentes.

Ainsi, un premier système AFE est associé à la bande basse B1. Il comprend un module de traitement numérique couche physique 211, un module de conversion fréquence/temps ou temps/fréquence 221, un module de conversion numérique/analogique 231, un filtre d'émission EF1 251, un filtre de réception RF1 271, un module d'amplification à gain contrôlé 281, et un module de conversion analogique/numérique 291.

Un deuxième système AFE est associé à la bande haute B2. Il comprend un module de traitement numérique couche physique 212, un module de conversion fréquence/temps ou temps/fréquence 222, un module de conversion numérique/analogique 232, un module d'atténuation 30, un filtre d'émission EF2 252, un filtre de réception RF2 272, un module d'amplification à gain contrôlé 282, et un module de conversion analogique/numérique 292.

Ces deux systèmes AFE comprennent également un module de traitement numérique au niveau de la couche MAC 31 et un module de couplage 26 au réseau secteur communs aux deux bandes.

Plus précisément, pour la première bande B1, l'échantillonnage peut être réalisé à basse fréquence, de l'ordre de 80 MHz, afin d'employer des convertisseurs numérique/analogique 231 et analogique/numérique 291 peu coûteux. Par contre, l'échantillonnage de la deuxième bande B2 est préférentiellement de l'ordre de 200 MHz au moins.

Avec cette configuration, le profil de puissance de la figure 1 est obtenu par atténuation (30) relative du signal d'émission après conversion numérique/analogique 232 de la bande haute B2 de 30 dB par rapport à celui de la première bande B1. Dans ce cas, le rapport signal à bruit en sortie du convertisseur numérique/analogique 232 de la deuxième bande B2 peut être conservé après atténuation, et rester suffisant pour envisager des modulations à grand nombre d'états sur la deuxième bande B2.

Toutefois, cette technique consistant à dédoubler le système AFE présente plusieurs inconvénients.

Un premier inconvénient de cette technique est la complexité requise pour transmettre simultanément des données sur les première et deuxième bandes, puisque chacune des deux bandes nécessite son propre système AFE et un traitement numérique couche physique entièrement ou en grande partie distinct.

Un autre inconvénient de cette technique est son coût en termes de ressource, du fait de la duplication de la plupart des modules.

Encore un autre inconvénient de cette technique est la difficulté de réalisation des filtres analogiques d'émission au niveau de la première bande et de réception au niveau de la deuxième bande, qui doivent être très sélectifs.

En effet, le filtre d'émission EF1 251 doit pouvoir éliminer la première composante harmonique de la réponse du convertisseur numérique/analogique 231 de la première bande. Or cette première bande se situe, après recombinaison des deux systèmes AFE, 30 dB au-dessus de la deuxième bande (du fait du profil de puissance illustré à la figure 1). Le filtre d'émission EF1 251 doit donc être très sélectif en fréquence pour que la deuxième bande B2 ne soit pas perturbée par le convertisseur numérique/analogique 231 de la première bande B1.

De plus, la réponse du filtre de réception RF2 272, avant échantillonnage de la deuxième bande B2, doit présenter de bonnes sélectivité et réjection hors bande, afin que la portion de la première bande B1 qui entre dans la bande du filtre de réception RF2 reste à un niveau de puissance faible devant celui de la deuxième bande B2.

Ainsi, malgré ce dédoublement du système AFE, certaines contraintes portant sur le filtrage en analogique restent difficiles à respecter.

Il existe donc un besoin pour une nouvelle technique de filtrage permettant de pallier au moins certains de ces inconvénients.

### 3. Exposé de l'invention

L'invention propose un dispositif d'émission d'un signal analogique par courants porteurs en ligne selon la revendication 1. L'invention propose également un dispositif de réception d'un signal analogique transmis par courants porteurs en ligne selon la revendication 7.

Un dispositif d'émission ou de réception selon l'invention utilise un filtre de pondération adapté pour les transmissions par courants porteurs en ligne dans une bande de fréquence élargie.

Par exemple, la première sous-bande est de l'ordre de 0 à 30 MHz, et la deuxième sous-bande de l'ordre de 30 à 87,5 MHz. L'invention propose ainsi de traiter conjointement la bande basse (première sous-bande) et les fréquences inférieures à 87,5 MHz de la bande haute.

Un tel filtre de pondération, utilisé en émission et/ou en réception permet de respecter et/ou de recevoir le profil de densité spectrale de puissance illustré en figure 1, selon lequel la puissance maximale de la deuxième sous-bande doit être inférieure de 30 dB par rapport à celle de la première sous-bande.

Selon un premier aspect de l'invention, les moyens d'atténuation comprennent un atténuateur à résistance.

La première branche du filtre de pondération correspond donc à un trajet direct atténué.

En particulier, un tel atténuateur est particulièrement simple à implémenter.

De plus, le choix des valeurs de résistances permet de respecter le profil de densité spectrale de puissance illustré en figure 1. En particulier, l'atténuation correspond à la différence de puissance entre les première et deuxième sous-bandes (30 dB pour une transmission par CPL), augmentée de la perte liée à l'insertion du filtre de pondération dans la bande de fréquence (par exemple 6 dB).

Selon une autre caractéristique, les moyens de filtrage comprennent trois cellules de filtrage, dont deux cellules de type « cellule en M » encadrant une cellule de type « cellule à K constant ».

Les moyens de filtrage de la deuxième branche sont ainsi faciles à implémenter à partir de cellules de filtrage connues.

Ces cellules de filtrage permettent d'obtenir un filtre passe-bas (pour l'émission) ou passe-haut (pour la réception) très sélectif en fréquence.

Selon encore une autre caractéristique, les moyens de combinaison comprennent un amplificateur différentiel. Les deux branches du filtre de pondération peuvent donc être recombinées par l'intermédiaire d'un amplificateur différentiel.

Un tel amplificateur différentiel est bien adapté au traitement des signaux analogiques. De plus, il s'agit d'un élément bien connu et facile à implémenter.

Un dispositif d'émission selon la revendication 1 correspond par exemple à l'interface analogique d'entrée (AFE) d'un équipement d'un réseau de communication.

Selon l'invention, un tel dispositif d'émission présente une structure simplifiée par rapport aux systèmes AFE à bande élargie selon l'état de la technique.

En particulier, un tel dispositif d'émission permet de s'affranchir de la duplication de la plupart des éléments d'un système AFE classique pour pouvoir fonctionner en bande élargie et de simplifier le traitement du signal couche physique par l'emploi d'une seule et même couche physique pour la bande globale 0-87 MHz.

Finalement, un tel dispositif permet de générer un signal d'émission respectant le profil de puissance de la figure 1.

En particulier, un tel dispositif d'émission comprend :

- un module de traitement numérique de données à émettre, au niveau de la couche physique, délivrant un signal numérique ;
- un module de conversion fréquence-temps du signal numérique ;
- un module de conversion numérique-analogique du signal numérique dans le domaine temporel, délivrant le signal analogique ;
- un module d'amplification du signal analogique, alimentant le filtre de pondération.

On note que la mise en oeuvre du filtre de pondération après conversion numérique/analogique permet de conserver un rapport signal à bruit de conversion numérique/analogique identique quelque soit la sous-bande considérée (0-30 MHz ou 30-87 MHz).

De plus, le profil de puissance obtenu sur les deux sous-bandes en sortie du module de conversion numérique-analogique est uniforme.

Selon un mode de réalisation particulier, les moyens de filtrage du filtre de pondération comprennent trois cellules de filtrage, dont deux cellules de type « cellule en M » encadrant une cellule de type « cellule à K constant ». Les cellules en M comprennent chacune trois composants inductifs et un composant capacitif, et la cellule à K constant comprend deux composants inductifs et un composant capacitif, chacun des composants inductifs de la cellule à K constant pouvant être regroupé avec un composant inductif d'une des cellules en M. En d'autres termes, l'association de ces trois cellules de filtrage permet de regrouper, aux deux interfaces, deux composants inductifs en un seul.

Les moyens de filtrage du filtre de pondération sont ainsi construits en utilisant des cellules de type connu. Comme déjà indiqué, ces cellules de filtrage permettent d'obtenir un filtre passe-bas (en émission) ou passe-haut (en réception), sans modifier la structure des moyens de filtrage, en permutant simplement les composants inductifs et capacitifs.

Un dispositif de réception selon la revendication 7 correspond par exemple à l'interface analogique d'entrée (AFE) d'un équipement d'un réseau de communication.

En particulier, l'utilisation d'un filtre de pondération présentant une structure identique en émission et en réception permet d'obtenir une bonne recombinaison des signaux. En d'autres termes, la mise en cascade du dispositif d'émission décrit ci-dessus et du dispositif de réception permet de restituer un profil de puissance uniforme.

En particulier, un tel dispositif de réception comprend :

- un module d'amplification à gain contrôlé du signal analogique issu du filtre de pondération ;
- un module de conversion analogique-numérique du signal analogique amplifié, délivrant un signal numérique ;
- un module de conversion temps-fréquence du signal numérique ;
- un module de traitement numérique du signal numérique dans le domaine fréquentiel, au niveau de la couche physique, permettant de reconstruire des données émises.

On note que la mise en oeuvre du filtre de pondération avant conversion analogique/numérique permet de conserver un rapport signal à bruit de conversion analogique/numérique identique quelque soit la sous-bande considérée (0-30 MHz ou 30-87 MHz).

De plus, le profil de puissance obtenu sur les deux sous-bandes en entrée du module de conversion analogique/numérique est uniforme.

Selon un mode de réalisation particulier, les moyens de filtrage du filtre de pondération comprennent trois cellules de filtrage, dont deux cellules de type « cellule en M » encadrant une cellule de type « cellule à K constant ». Les cellules en M comprennent chacune trois composants capacitifs et un composant inductif, et la cellule à K constant comprend deux composants capacitifs et un composant inductif, chacun des composants capacitifs de la cellule à K constant pouvant être regroupé avec un composant capacitif d'une des cellules en M. En d'autres termes, l'association de ces trois cellules de filtrage permet de regrouper, aux deux interfaces, deux composants capacitifs en un seul.

Dans un autre mode de réalisation, l'invention concerne un procédé d'émission d'un signal analogique par courants porteurs en ligne selon la revendication 13.

Un tel procédé d'émission peut être mis en oeuvre par un dispositif d'émission tel que décrit précédemment. Les avantages de ce procédé sont similaires à ceux du dispositif correspondant, et ne sont pas décrits de nouveau.

Dans encore un autre mode de réalisation, l'invention concerne un procédé de réception d'un signal analogique transmis par courants porteurs en ligne selon la revendication 14.

Un tel procédé de réception peut être mis en oeuvre par un dispositif de réception tel que décrit précédemment. Les avantages de ce procédé sont similaires à ceux du dispositif correspondant, et ne sont pas décrits de nouveau.

Un autre aspect de l'invention concerne un programme d'ordinateur comportant des instructions adaptées à la mise en oeuvre des procédés d'émission et/ou de réception présentés ci-dessus, lorsque le programme est exécuté par un processeur. Un tel programme peut utiliser n'importe quel langage de programmation. Il peut être téléchargé depuis un réseau de communication et/ou enregistré sur un support lisible par ordinateur.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- la figure 1, présentée en relation avec l'art antérieur, illustre le profil de puissance que doivent respecter les signaux émis dans la bande de fréquence 0 - 500 MHz ;
- les figures 2 et 3, également décrites en relation avec l'art antérieur, présentent la structure d'un système AFE classique pour une transmission sur la bande basse et la structure d'un système AFE dédoublé pour une transmission sur une bande élargie ;
- la figure 4 illustre la structure d'un filtre de pondération mis en oeuvre dans un dispositif d'émission ou de réception selon l'invention ;
- les figures 5A à 5C rappellent les caractéristiques des cellules « en M » et « à K constant » intervenant dans le filtre de pondération de la figure 4 ;
- la figure 6 illustre la structure d'un système AFE mettant en oeuvre, en émission et en réception, le filtre de pondération de la figure 4 ;
- la figure 7 représente les niveaux de puissance des différentes sous-bandes en entrée et en sortie des filtres de pondération du système de la figure 6 ;
- les figures 8A et 8B illustrent les fonctions de transfert en amplitude et en phase d'un filtre de pondération mis en oeuvre dans un dispositif d'émission ou de réception selon l'invention, utilisé en émission ;
- les figures 9A et 9B illustrent les fonctions de transfert en amplitude et en phase d'un filtre de pondération mis en oeuvre dans un dispositif d'émission ou de réception selon l'invention, utilisé en réception ;
- les figures 10A et 10B représentent le résultat global des filtrages de pondération en émission et en réception.

### 5. Description d'un mode de réalisation de l'invention

*5.1 Principe général*

Le principe général de l'invention repose sur l'utilisation d'une structure de filtres sélectifs en fréquence, dits « filtres de pondération », dans la partie analogique d'un émetteur et/ou d'un récepteur d'un signal analogique transmis par courants porteurs en ligne.

Cette nouvelle structure permet notamment de réaliser des communications sur une large bande de fréquence, formée de deux sous-bandes adjacentes, par exemple une première sous-bande de l'ordre de 0 à 30 MHz et une deuxième sous-bande de l'ordre de 30 à 87,5 MHz, tout en respectant un profil de puissance prédéterminé.

De tels filtres de pondération peuvent être de type passe-bas en émission, ou passe-haut en réception. La structure de ces filtres de pondération est identique en émission et en réception, et les filtres d'émission ne diffèrent des filtres de réception que par la permutation des composants inductifs et capacitifs.

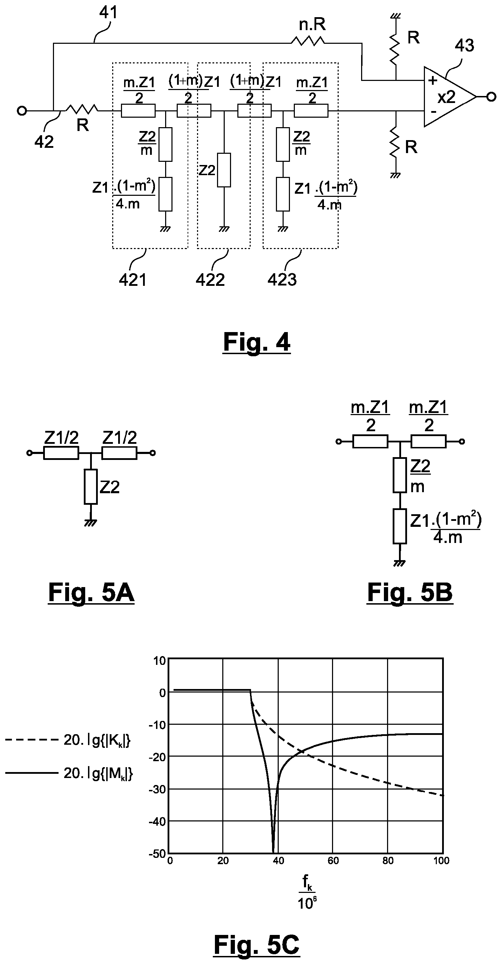

La figure 4 illustre plus précisément la structure d'un filtre de pondération destiné à être implémenté dans un dispositif d'émission ou de réception selon l'invention.

Un tel filtre de pondération comprend deux branches, dites première branche 41 et deuxième branche 42, et des moyens de combinaison 43 des signaux issus des première et deuxième branches, prenant par exemple la forme d'un amplificateur différentiel.

Plus précisément, la première branche 41 comprend des moyens d'atténuation du signal analogique, prenant par exemple la forme d'un atténuateur à résistance. De manière tout à fait conventionnelle, on considère que le signal d'entrée est issu d'un générateur de tension, de type AOP (amplificateur opérationnel) par exemple, et est appliqué en entrée du filtre de pondération, et donc de la première branche 41. L'atténuateur à résistance peut alors être simplement constitué de deux résistances montées en pont diviseur, tel que classiquement mis en oeuvre en électronique. Conformément à la figure 4, la valeur de l'atténuation est alors donnée par la relation :

$$\text{atténuation (dB)} = 20 \text{x} \log(R/(R+n\text{x}R))$$

Pour n= 62, l'atténuation est alors de 36 dB.

La deuxième branche 42 comprend quant à elle des moyens de filtrage du signal analogique, présentant une bande passante correspondant à la première sous-bande si le filtre de pondération est utilisé en émission, ou bien à la deuxième sous-bande si le filtre de pondération est utilisé en réception. De manière tout à fait conventionnelle, on considère que le signal d'entrée est issu d'un générateur de tension, de type AOP (amplificateur opérationnel) par exemple, et est appliqué en entrée du filtre de pondération, et donc de la deuxième branche 42. Les moyens de filtrage du filtre de pondération comprennent trois cellules de filtrage 421 à 423, dont deux cellules de type « cellule en M » encadrant une cellule de type « cellule à K constant ». Classiquement, les cellules de filtrage en M et à K constant doivent être adaptées en impédance de source, en entrée, et en impédance de charge, en sortie. Un générateur de tension étant appliqué en entrée de la deuxième branche 42, une première résistance R située avant les cellules de filtrage permet d'imposer une impédance de source. De la même manière, en sortie de la deuxième branche 42, une seconde résistance R permet d'imposer une impédance de charge avant recombinaison des deux branches 41 et 42 par un amplificateur différentiel. De cette manière, la perte d'insertion du filtre de pondération dans la bande passante est de 6 dB.

Pour rappel, les figures 5A à 5C illustrent respectivement la structure d'une cellule à K constant, la structure d'une cellule en M, et les courbes de réponse de ces deux types de cellule, pour un exemple de filtre passe-bas de 30 MHz de bande passante, avec $Z1 = j.L.\omega$, $Z2 = 1 / j.C.\omega$ et m = 0,6.

On rappelle que la cellule en M est une cellule dérivée de la cellule à K constant, améliorant les caractéristiques de la cellule à K constant, et dont les propriétés sont principalement : une même bande passante que la cellule à K constant, une impédance quasi-constante dans la bande passante, un zéro de transmission hors bande qui permet d'améliorer la sélectivité du filtre au voisinage de la fréquence de coupure, une réjection hors-bande lointaine partielle.

Sur la base de cette cellule en M, l'invention propose un dispositif d'émission ou de réception d'un signal analogique par courants porteurs en ligne utilisant un filtre de pondération générique, dont la complexité reste comparable à celle d'un filtre passe-bas ou passe-haut classique, et qui permet, suivant le type des composants Z1 et Z2 (capacitif ou inductif), de réaliser une pondération en émission ou en réception.

Plus précisément, si le filtre de pondération est utilisé en émission, les cellules en M 421 et 423 de la deuxième branche comprennent chacune trois composants inductifs (Z1) et un composant capacitif (Z2), et la cellule à K constant 422 comprend deux composants inductifs (Z1) et un composant capacitif (Z2). Comme illustré en figure 4, chacun des composants inductifs de la cellule à K constant ($Z1 / 2$) peut être regroupé avec un composant inductif d'une des cellules en M ($mZ1 / 2$), pour former un unique composant inductif (($1 + m)Z1 / 2$).

Si le filtre de pondération est utilisé en réception, les cellules en M 421 et 423 de la deuxième branche comprennent chacune trois composants capacitifs (Z1) et un composant inductif (Z2), et la cellule à K constant 422 comprend deux composants capacitifs (Z1) et un composant inductif (Z2). A nouveau, comme illustré en figure 4, chacun des composants capacitifs de la cellule à K constant ($Z1 / 2$) peut être regroupé avec un composant capacitif d'une des cellules en M ($Z2 / 2$) pour former un unique composant capacitif (($1 + m)Z1 / 2$).

Le filtre de pondération ainsi obtenu permet alors :

- lorsqu'il est mis en oeuvre à l'émission : d'appliquer un filtre passe-bas à un signal transmis dans la première sous-bande de fréquence (grâce à la deuxième branche du filtre de pondération) ou d'atténuer la puissance d'un signal transmis dans la deuxième sous-bande de fréquence (grâce à la première branche du filtre de pondération) ;
- lorsqu'il est mis en oeuvre en réception : d'appliquer un filtre passe-haut à un signal transmis dans la deuxième sous-bande de fréquence grâce à la deuxième branche du filtre de pondération) ou d'atténuer la puissance d'un signal transmis dans la première sous-bande de fréquence (grâce à la première branche du filtre de pondération).

*5.2 Application aux transmissions PLC*

On décrit ci-après l'application d'un dispositif d'émission ou de réception d'un signal analogique par courants porteurs en ligne selon l'invention aux transmissions PLC à bande élargie.

On rappelle que les transmissions PLC sont actuellement autorisées dans une bande de fréquence de l'ordre de 0 à 30 MHz, et qu'on envisage d'élargir cette bande de fréquence jusqu'à des valeurs de l'ordre de 500 MHz, afin d'augmenter les débits de transmission. Comme déjà indiqué en relation avec l'art antérieur, une contrainte pour cet élargissement de bande est la présence de la bande FM entre 87,5 et 108 MHz.

Les inventeurs ont constaté que la sous-bande 30-87,5 MHz nécessitait un traitement particulier. En particulier, si elle est rattachée à la bande basse (environ 0-30 MHz), son traitement impose des contraintes fortes de dynamique de signal et de complexité du système d'émission/réception, du fait de l'atténuation de 30 dB dans le profil de puissance à partir de 30 MHz. Si elle est traitée avec la bande haute jusqu'à 500 MHz, elle se trouve sous exploitée par une faible quantification, étant donné des caractéristiques d'affaiblissement du canal encore favorables dans cette sous-bande comparées à celles des bandes de fréquence plus élevées.

L'invention propose ainsi de traiter conjointement la bande basse (encore appelée première sous-bande) et les fréquences inférieures à 87,5 MHz de la bande haute (encore appelées deuxième sous-bande), en utilisant une structure particulière pour la partie analogique d'émission/réception d'un équipement d'un réseau, reposant sur la mise en oeuvre d'un nouveau filtre de pondération tel que décrit ci-dessus dans un dispositif d'émission ou un dispositif de réception d'un signal analogique par courants porteurs en ligne.

La solution proposée permet également de simplifier le traitement du signal couche physique par l'emploi d'une seule et même couche physique pour la bande globale 0-87 MHz.

En d'autres termes, l'invention permet de simplifier le principe de transmission PLC dans la bande 0-87 MHz par la mise en oeuvre d'une même couche physique et d'un seul système de type AFE pour la transmission des première et deuxième sous-bandes, tout en conservant un rapport signal à bruit de conversion numérique/analogique et analogique/numérique identique pour les deux sous-bandes, et en respectant le profil de puissance de la figure 1.

Pour y parvenir l'invention propose une solution de filtrage de pondération analogique peu complexe et aisément implantable dans le cadre d'une réalisation matérielle (« hardware »), dont les caractéristiques, de phase notamment, sont compatibles avec la transmission d'un signal OFDM.

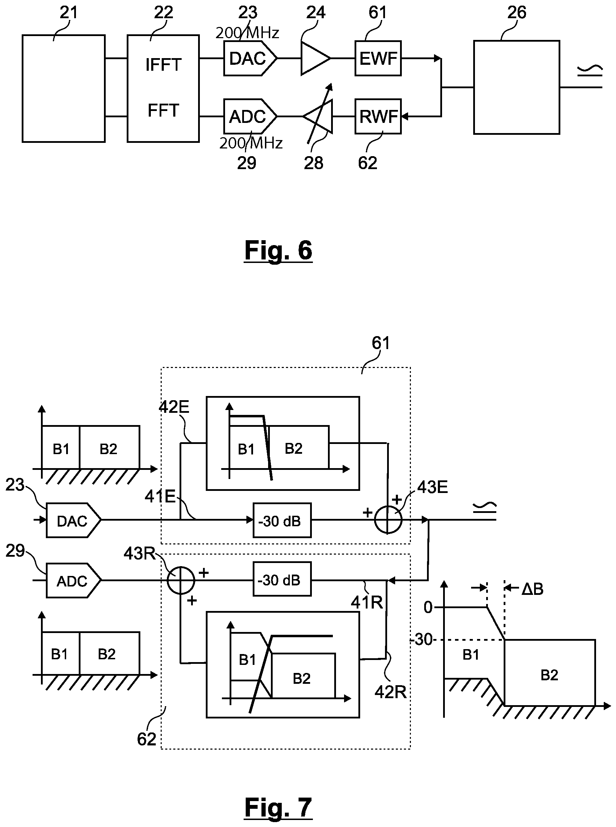

Comme illustré en figure 6, l'invention propose selon cet exemple d'application un nouveau système AFE, présentant une structure identique à celle des systèmes AFE classiques pour une transmission sur la bande basse, décrits en relation avec la figure 2, à l'exception des filtres d'émission 25 et réception 27 qui sont remplacés par des filtres de pondération analogiques d'émission 61 et de réception 62.

Les modules de traitement numérique 21 couche physique, conversion fréquence/temps ou temps/fréquence 22, conversion numérique/analogique 23 ou analogique/numérique 29, d'amplification 24, d'amplification à gain contrôlé 28 et de couplage 26 au réseau secteur sont similaires à ceux présentés en relation avec la figure 2 et ne sont donc pas décrits plus en détails. On note toutefois que la fréquence d'échantillonnage des modules de conversion numérique/analogique ou analogique/numérique peut être de l'ordre de 200 MHz.

Plus précisément, comme illustré en figure 7, le filtre de pondération d'émission 61 reçoit, en sortie du module conversion numérique/analogique 23, les deux sous-bandes B1 (environ 0-30 MHz) et B2 (environ 30-87,5 MHz) suivant une répartition en puissance uniforme. Ce filtre met en forme le profil de puissance de la figure 1 (écart de niveau de 30 dB dans le profil de puissance entre la sous-bande B1 et la sous-bande B2).

En réception, le filtre de pondération 62 effectue l'opération inverse et restitue une réponse uniforme avant conversion analogique/numérique 29.

Comme décrit en relation avec la figure 4, le filtre de pondération d'émission 61 comprend deux branches, une première branche 41E comprenant un atténuateur à résistance de 30+6 dB, où le facteur n vaut par exemple 62, et une deuxième branche 42E comprenant un filtre passe-bas de bande passante B1, éventuellement de mêmes caractéristiques que le filtre d'émission EF1 251 illustré en figure 3. Un tel filtre passe-bas est composé de trois cellules de filtrage, comprenant deux cellules en M de part et d'autre d'une cellule à K constant, et introduit une perte de 6 dB dans la bande passante. La somme 43E de la sortie du filtre passe-bas avec celle de l'atténuateur permet d'approcher le profil de puissance imposé tout en conservant un rapport signal à bruit identique pour les deux sous-bandes en sortie de l'AFE, comme illustré en figure 7. Néanmoins, selon la pente d'atténuation du filtre passe-bas, il faut considérer une bande de transition ΔB plus ou moins large dans laquelle le niveau de puissance de la sous-bande B1 n'est pas optimal.

Le filtre de pondération en réception 62 comprend également deux branches, une première branche 41R comprenant un atténuateur à résistance de 30+6 dB et une deuxième branche 42R comprenant un filtre passe-haut de bande passante B2, éventuellement de mêmes caractéristiques que le filtre de réception RF2 272 illustré en figure 3. Un tel filtre passe-haut est composé de trois cellules de filtrage, comprenant deux cellules en M de part et d'autre d'une cellule à K constant, et introduit une perte de 6 dB dans la bande passante. La somme 43R de la sortie du filtre passe-haut avec celle de l'atténuateur permet de reconstituer une réponse uniforme avant conversion analogique/numérique 29, et ainsi maintenir un rapport signal à bruit identique pour les deux sous-bandes B1 et B2.

L'atténuation de 6dB supplémentaire par rapport aux 30 dB requis par le profil de puissance sur la première branche en émission et en réception correspond à la perte de 6 dB liée à l'introduction des moyens de filtrage sur la deuxième branche, qui doivent être adaptés en impédance de source et de charge par des résistances R telles que représentées à la figure 4.

On note également que, comme pour le système à deux AFE illustré en figure 3, l'efficacité du système d'émission/réception selon l'invention dépend de la sélectivité des filtres d'émission/réception. Ainsi, plus la pente d'atténuation de ces filtres est importante, meilleure est l'efficacité du système. Pour atteindre ces performances, il est souhaitable d'utiliser des filtres analogiques d'ordre élevé, qui pourraient être plus complexes à implanter si l'on considère les cellules à K constant classiquement utilisées.

C'est pourquoi les inventeurs ont proposé un nouveau filtre de pondération comprenant des moyens de filtrage spécifiques, mettant en oeuvre deux cellules en M et une cellule à K constant. L'utilisation de cellules en M permet en effet d'obtenir une pente d'atténuation élevée, et donc une bande de transition réduite, alors que la cellule à K constant permet d'atteindre une atténuation hors bande élevée par rapport à -36 dB.

Finalement, l'association de ces trois cellules en T conduit à une rotation de phase qui, au point de recombinaison des deux branches 41E et 42E (respectivement 41R et 42R), est de $3\pi$. Cette recombinaison est ainsi avantageusement effectuée par un amplificateur différentiel, 43E (respectivement 43R), qui est non inverseur pour la première branche et inverseur pour la seconde, et qui est classiquement employé dans les étages de traitement de signal analogique.

La fonction de transfert du filtre de pondération peut donc s'exprimer sous la forme suivante :

$$T_k = \frac{2Zb_k}{\left(R + Za_k + Zb_k\right)}\frac{Xb_k}{\left(Xb_k + Zd_k\right)}\frac{Zb_k}{\left(Ze_k + Zb_k\right)}\frac{R}{\left(Zf_k + R\right)} - 2Hp_k$$

avec :

- $$Za_k = \frac{mZ1_k}{2}, \quad Zb_k = \frac{Z2_k}{m} + \frac{\left(1 - m^2\right)}{4m}Z1_k, \quad Zc_k = \frac{1+m}{2}Z1_k, \quad Zd_k = \frac{\left(R + Za_k\right)Zb_k}{R + Za_k + Zb_k} + Zc_k$$

$$Ze_k = \frac{Zd_kZ2_k}{Zd_k + Z2_k} + Zc_k, \quad Zf_k = \frac{Ze_kZb_k}{Ze_k + Zb_k} + Za_k, \quad Hp_k = \frac{1}{1+n},$$

- R la résistance utilisée dans l'atténuateur à résistance, par exemple égale à 22,5 ohms en émission et 24,5 ohms en réception ;
- Z1 un composant inductif et Z2 un composant capacitif pour le filtre de pondération d'émission, ou inversement Z1 un composant capacitif et Z2 un composant inductif capacitif pour le filtre de pondération en réception ;
- n un facteur égal à 62 par exemple, choisi pour obtenir une atténuation de 36 dB ;
- m un coefficient d'amortissement égal à 0,65 par exemple.

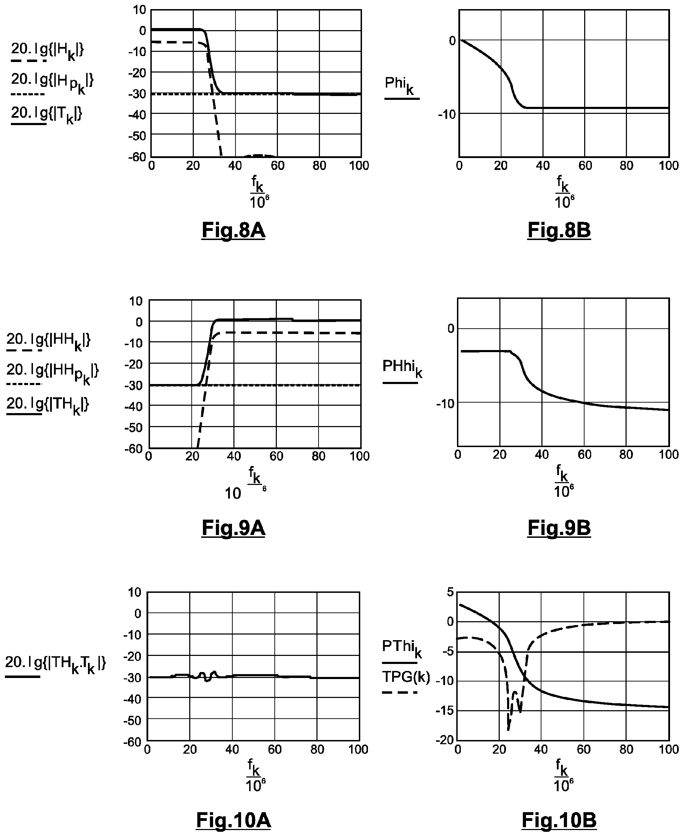

A titre d'exemples, les figures 8A, 8B, 9A et 9B illustrent les fonctions de transfert en amplitude et en phase des moyens de filtrage des filtres de pondération, en émission et en réception.

Ainsi, la figure 8A illustre la fonction de transfert en amplitude et la figure 8B la fonction de transfert en phase que l'on peut obtenir en émission, sur une bande de 0 à 100 MHz, avec les paramètres suivants, où Z1 est inductif et Z2 capacitif :

$$Fc = 27.10^6$$

$$R = 22,5$$

$$C = 3,9.10^{-10}$$

$$L = 3,564.10^{-7}$$

$$Z1_k = jL\omega_k$$

$$Z2_k = \frac{1}{jC\omega_k}$$

$$\Omega = 2\pi Fc$$

$$m = 0,65$$

$$n = 62$$

Pour la réponse en amplitude de la figure 8A, figurent en traits hachurés les réponses des deux branches 41E et 42E et en trait plein la réponse finale en sortie de l'amplificateur 43E. On obtient donc le profil de puissance recherché avec une bande de transition ∆B réduite, de l'ordre de 4 MHz, et une réponse en phase sans discontinuité sur l'ensemble des sous-bandes B1 et B2.

De la même façon, la figure 9A illustre la fonction de transfert en amplitude et la figure 9B la fonction de transfert en phase que l'on peut obtenir en réception, sur une bande de 0 à 100 MHz, avec les paramètres suivants, où Z1 est cette fois capacitif et Z2 inductif :

$$Fc = 28,9.10^6$$

$$R = 24,5$$

$$C = 8,2.10^{-11}$$

$$L = 9,246.10^{-8}$$

$$Z1_k = \frac{1}{jC\omega_k}$$

$$Z2_k = jL\omega_k$$

$$\Omega = 2\pi Fc$$

$$m = 0,65$$

$$n = 62$$

Pour la réponse en amplitude de la figure 9A, figurent en traits hachurés les réponses des deux branches 41R et 42R et en trait plein la réponse finale en sortie de l'amplificateur 43R. On obtient donc réponse en amplitude complémentaire de celle d'émission, et la réponse en phase reste aussi continue sur la plage totale de fréquence.

Selon ces exemples de filtres de pondération d'émission et de réception, le choix des différents paramètres a été effectué de manière à ce que les composants, s'ils ne sont tous intégrables, puissent être tout au moins implantés sous un très faible encombrement (de l'ordre de 1.6x0.8 mm$^2$ ou 1.0x0.5 mm$^2$ par exemple), tout à fait compatible avec les contraintes de réalisation matérielle actuelles.

Un fonctionnement optimal du système AFE selon l'invention est obtenu en considérant des conditions de distorsion du signal négligeables en regard de celles du canal de transmission.

Les figures 10A et 10B illustrent ainsi les caractéristiques du filtrage global, en amplitude (10 dB par division) et en phase (5 radians par division), lorsque les deux filtres de pondération d'émission et de réception sont cascadés.

On constate sur la figure 10A que la réponse en amplitude est bien linéaire, à l'exception d'une légère sur-oscillation sur +/-2 dB localisée dans la bande de transition des moyens de filtrage des filtres de pondération. Pour un signal OFDM, et compte tenu des dégradations du canal, cette distorsion peut être considérée comme marginale.

De même, la réponse en phase illustrée en figure 10B (en trait plein) reste progressive et continue sur l'ensemble de la bande utile, exceptée dans la bande de transition, où l'on observe une légère rupture du temps de propagation de groupe (en trait hachuré) de l'ordre de 150 ns (50 ns/division), ce qui reste peu significatif pour le système de transmission en objet.

Les filtres de pondération proposés en émission et en réception, situés respectivement après conversion numérique/analogique et avant conversion analogique/numérique sont donc complémentaires.

*5.3 Variantes*

Afin d'améliorer encore ce système, il est possible d'effectuer une précorrection à l'émission sur certaines porteuses du signal OFDM, avant IFFT, en numérique. Il est ainsi possible de diminuer notablement la largeur de la bande de transition en accentuant localement le niveau de puissance des porteuses situées à la fréquence de coupure du filtre de pondération en émission, et ce sans pour autant réduire significativement le rapport signal à bruit de conversion numérique analogique, puisque l'accroissement de puissance est effectué sur une portion très étroite du spectre.

Il est également possible de pré-corriger la sur-oscillation d'amplitude de la réponse globale de pondération.

## Revendications

1. Dispositif d'émission d'un signal analogique par courants porteurs en ligne, **caractérisé en ce qu'**il comprend un filtre de pondération (61) comprenant :

   - une première branche (41) comprenant des moyens d'atténuation pour atténuer un signal analogique d'entrée;
   - une deuxième branche (42) comprenant des moyens de filtrage pour filtrer ledit signal analogique d'entrée, comprenant un filtre passe-bas dont la fréquence de coupure est de l'ordre de 30MHz ;
   - des moyens de combinaison (43) des signaux issus desdites première et deuxième branches, pour délivrer un signal analogique combiné ;

   et un module de couplage au réseau électrique, pour transmettre ledit signal analogique combiné par courants porteurs en ligne dans une bande de fréquence de l'ordre de 0 à 87,5MHz.

2. Dispositif d'émission selon la revendication 1, **caractérisé en ce qu'**il comprend en outre :

   - un module de traitement numérique (21) de données à émettre, au niveau de la couche physique, pour délivrer un signal numérique ;
   - un module de conversion fréquence-temps (22) pour convertir ledit signal numérique ;
   - un module de conversion numérique-analogique (23) pour convertir ledit signal numérique dans le domaine temporel, pour délivrer ledit signal analogique d'entrée ;
   - un module d'amplification (24) pour amplifier ledit signal analogique d'entrée, et pour alimenter ledit filtre de pondération (61).

3. Dispositif d'émission selon la revendication 1, **caractérisé en ce que** les moyens de filtrage dudit filtre de pondération comprennent trois cellules de filtrage, dont deux cellules de type « cellule en M » encadrant une cellule de type « cellule à K constant »,
   lesdites cellules en M comprenant chacune trois composants inductifs et un composant capacitif et ladite cellule à K constant comprenant deux composants inductifs et un composant capacitif,
   chacun des composants inductifs de ladite cellule à K constant pouvant être regroupé avec un composant inductif d'une desdites cellules en M.

4. Dispositif d'émission selon la revendication 1, **caractérisé en ce que** lesdits moyens d'atténuation comprennent un atténuateur à résistance.

5. Dispositif d'émission selon la revendication 1, **caractérisé en ce que** lesdits moyens de combinaison comprennent un amplificateur différentiel.

6. Dispositif d'émission selon la revendication 1, **caractérisé en ce que** la puissance dudit signal analogique combiné est conforme à un profil de puissance prédéterminé présentant une puissance maximale dans une deuxième sous-bande de fréquence inférieure de 30 dB par rapport à la puissance maximale dans une première sous-bande de fréquence, la première sous-bande étant de l'ordre de 0 à 30 MHz et la deuxième sous-bande étant de l'ordre de 30 à 87,5 MHz.

7. Dispositif de réception d'un signal analogique transmis par courants porteurs en ligne, **caractérisé en ce qu'**il comprend :

un module de couplage au réseau électrique, pour recevoir ledit signal analogique transmis par courants porteurs en ligne dans une bande de fréquence de l'ordre de 0 à 87,5MHz, et
un filtre de pondération (62) comprenant :

- une première branche (41) comprenant des moyens d'atténuation pour atténuer ledit signal analogique ;
- une deuxième branche (42) comprenant des moyens de filtrage pour filtrer ledit signal comprenant un filtre passe-haut dont la fréquence de coupure est de l'ordre de 30MHz ;
- des moyens de combinaison (43) pour combiner des signaux issus desdites première et deuxième branches, et pour délivrer un signal analogique combiné.

8. Dispositif de réception selon la revendication 7, **caractérisé en ce qu'**il comprend en outre :

- un module d'amplification à gain contrôlé (28) pour amplifier le signal analogique combiné issu dudit filtre de pondération (62) ;
- un module de conversion analogique-numérique (29) pour convertir ledit signal analogique amplifié, et pour délivrer un signal numérique ;
- un module de conversion temps-fréquence (22) pour convertir ledit signal numérique ;
- un module de traitement numérique (21) pour traiter ledit signal numérique dans le domaine fréquentiel, au niveau de la couche physique, et pour permettre de reconstruire des données émises.

9. Dispositif de réception selon la revendication 7, **caractérisé en ce que** les moyens de filtrage dudit filtre de pondération comprennent trois cellules de filtrage, dont deux cellules de type « cellule en M » encadrant une cellule de type « cellule à K constant »,
lesdites cellules en M comprenant chacune trois composants capacitifs et un composant inductif et ladite cellule à K constant comprenant deux composants capacitifs et un composant inductif,
chacun des composants capacitifs de ladite cellule à K constant pouvant être regroupé avec un composant capacitif d'une desdites cellules en M.

10. Dispositif de réception selon la revendication 7, **caractérisé en ce que** lesdits moyens d'atténuation comprennent un atténuateur à résistance.

11. Dispositif de réception selon la revendication 7, **caractérisé en ce que** lesdits moyens de combinaison comprennent un amplificateur différentiel.

12. Dispositif de réception selon la revendication 7, **caractérisé en ce que** la puissance dudit signal analogique est conforme à un profil de puissance prédéterminé présentant une puissance maximale dans une deuxième sous-bande de fréquence inférieure de 30 dB par rapport à la puissance maximale dans une première sous-bande de fréquence, la première sous-bande étant de l'ordre de 0 à 30 MHz et la deuxième sous-bande étant de l'ordre de 30 à 87,5 MHz.

13. Procédé d'émission d'un signal analogique par courants porteurs en ligne, **caractérisé en ce qu'**il comprend une étape de filtrage de pondération, mettant en oeuvre :

- une atténuation d'un signal analogique d'entrée ;
- un filtrage dudit signal analogique d'entrée mettant en oeuvre un filtre passe-bas dont la fréquence de coupure est de l'ordre de 30MHz;
- une combinaison des signaux issus desdites étapes d'atténuation et de filtrage, délivrant un signal analogique combiné

et une étape de couplage au réseau électrique, pour transmettre ledit signal analogique combiné par courants porteurs en ligne dans une bande de fréquence de l'ordre de 0 à 87,5MHz.

14. Procédé de réception d'un signal analogique transmis par courants porteurs en ligne, **caractérisé en ce qu'**il comprend

une étape de couplage au réseau électrique, pour recevoir ledit signal analogique transmis par courants porteurs en ligne dans une bande de fréquence de l'ordre de 0 à 87,5MHz,

une étape de filtrage de pondération dudit signal analogique, mettant en oeuvre :

- une atténuation dudit signal analogique ;
- un filtrage dudit signal analogique, mettant en oeuvre un filtre passe-haut dont la fréquence de coupure est de l'ordre de 30MHz ;
- une combinaison (43) des signaux issus desdites étapes d'atténuation et de filtrage, délivrant un signal analogique combiné.

**15.** Programme d'ordinateur comportant des instructions pour la mise en oeuvre d'un procédé selon l'une quelconque des revendications 13 et 14 lorsque ledit programme est exécuté par un processeur.

**Patentansprüche**

**1.** Vorrichtung zum Senden eines analogen Signals über Powerline, **dadurch gekennzeichnet, dass** sie einen Gewichtungsfilter (61) umfasst, umfassend:

- einen ersten Strang (41), der Dämpfungsmittel zum Dämpfen eines analogen Eingangssignals umfasst;
- einen zweiten Strang (42), der Filtermittel zum Filtern des analogen Eingangssignals umfasst, umfassend einen Tiefpassfilter, dessen Grenzfrequenz in der Größenordnung von 30 MHz liegt;
- Kombinationsmittel (43) für die aus dem ersten und zweiten Strang kommenden Signale, um ein kombiniertes analoges Signal auszugeben;

und ein Modul zur Kopplung mit dem Stromnetz, um das kombinierte analoge Signal über Powerline in einem Frequenzband in der Größenordnung von 0 bis 87,5 MHz zu übertragen.

**2.** Sendevorrichtung nach Anspruch 1, **dadurch gekennzeichnet, dass** sie ferner umfasst:

- ein Modul zur digitalen Verarbeitung (21) von zu sendenden Daten auf Ebene der physischen Schicht, um ein digitales Signal auszugeben;
- ein Frequenz-Zeit-Umsetzungsmodul (22) zum Umsetzen des digitalen Signals;
- ein Digital-Analog-Umsetzungsmodul (23) zum Umsetzen des digitalen Signals im Zeitbereich, um das analoge Eingangssignal auszugeben;
- ein Verstärkungsmodul (24) zum Verstärken des analogen Eingangssignals und zum Speisen des Gewichtungsfilters (61).

**3.** Sendevorrichtung nach Anspruch 1, **dadurch gekennzeichnet, dass** die Filtermittel des Gewichtungsfilters drei Filterzellen umfassen, darunter zwei Zellen vom Typ "M-Zelle", die eine Zelle vom Typ "K-konstant-Zelle" einrahmen, wobei die M-Zellen jeweils drei induktive Bauelemente und ein kapazitives Bauelement umfassen und die K-konstant-Zelle zwei induktive Bauelemente und ein kapazitives Bauelement umfasst, wobei jedes der induktiven Bauelemente der K-konstant-Zelle mit einem induktiven Bauelement einer der M-Zellen gruppiert werden kann.

**4.** Sendevorrichtung nach Anspruch 1, **dadurch gekennzeichnet, dass** die Dämpfungsmittel ein Dämpfungsglied mit Widerstand umfassen.

**5.** Sendevorrichtung nach Anspruch 1, **dadurch gekennzeichnet, dass** die Kombinationsmittel einen Differenzverstärker umfassen.

**6.** Sendevorrichtung nach Anspruch 1, **dadurch gekennzeichnet, dass** die Leistung des kombinierten analogen Signals einem vorbestimmten Leistungsprofil entspricht, das eine maximale Leistung in einem zweiten Frequenzteilband aufweist, die um 30 dB geringer als die maximale Leistung in einem ersten Frequenzteilband ist, wobei das erste Teilband in der Größenordnung von 0 bis 30 MHz liegt und das zweite Teilband in der Größenordnung von 30 bis 87,5 MHz liegt.

**7.** Vorrichtung zum Empfangen über Powerline übertragenen analogen Signals, **dadurch gekennzeichnet, dass** sie umfasst:

ein Modul zur Kopplung mit dem Stromnetz, um das über Powerline in einem Frequenzband in der Größenordnung von 0 bis 87,5 MHz übertragene analoge Signal zu empfangen, und
einen Gewichtungsfilter (62), umfassend:

- einen ersten Strang (41), der Dämpfungsmittel zum Dämpfen des analogen Signals umfasst;
- einen zweiten Strang (42), der Filtermittel zum Filtern des Signals umfasst, umfassend einen Hochpassfilter, dessen Grenzfrequenz in der Größenordnung von 30 MHz liegt;
- Kombinationsmittel (43) zum Kombinieren der aus dem ersten und zweiten Strang kommenden Signale und um ein kombiniertes analoges Signal auszugeben.

8.  Empfangsvorrichtung nach Anspruch 7, **dadurch gekennzeichnet, dass** sie ferner umfasst:

- ein Verstärkungsmodul mit gesteuerter Verstärkung (28) zum Verstärken des aus dem Gewichtungsfilter (62) kommenden kombinierten analogen Signals;
- ein Analog-Digital-Umsetzungsmodul (29) zum Umsetzen des verstärkten analogen Signals und zum Ausgeben eines digitalen Signals;
- ein Zeit-Frequenz-Umsetzungsmodul (22) zum Umsetzen des digitalen Signals;
- ein Modul zur digitalen Verarbeitung (21), um das digitale Signal im Frequenzbereich auf Ebene der physischen Schicht zu verarbeiten und um die Rekonstruktion der gesendeten Daten zu ermöglichen.

9.  Empfangsvorrichtung nach Anspruch 7, **dadurch gekennzeichnet, dass** die Filtermittel des Gewichtungsfilters drei Filterzellen umfassen, darunter zwei Zellen vom Typ "M-Zelle", die eine Zelle vom Typ "K-konstant-Zelle" einrahmen, wobei die M-Zellen jeweils drei kapazitive Bauelemente und ein induktives Bauelement umfassen und die K-konstant-Zelle zwei kapazitive Bauelemente und ein induktives Bauelement umfasst, wobei jedes der kapazitiven Bauelemente der K-konstant-Zelle mit einem kapazitiven Bauelement einer der M-Zellen gruppiert werden kann.

10. Empfangsvorrichtung nach Anspruch 7, **dadurch gekennzeichnet, dass** die Dämpfungsmittel ein Dämpfungsglied mit Widerstand umfassen.

11. Empfangsvorrichtung nach Anspruch 7, **dadurch gekennzeichnet, dass** die Kombinationsmittel einen Differenzverstärker umfassen.

12. Empfangsvorrichtung nach Anspruch 7, **dadurch gekennzeichnet, dass** die Leistung des analogen Signals einem vorbestimmten Leistungsprofil entspricht, das eine maximale Leistung in einem zweiten Frequenzteilband aufweist, die um 30 dB geringer als die maximale Leistung in einem ersten Frequenzteilband ist, wobei das erste Teilband in der Größenordnung von 0 bis 30 MHz liegt und das zweite Teilband in der Größenordnung von 30 bis 87,5 MHz liegt.

13. Verfahren zum Senden eines analogen Signals über Powerline, **dadurch gekennzeichnet, dass** es einen Gewichtungsfilterungsschritt umfasst, ausführend:

- eine Dämpfung eines analogen Eingangssignals;
- eine Filterung des analogen Eingangssignals, die einen Tiefpassfilter einsetzt, dessen Grenzfrequenz in der Größenordnung von 30 MHz liegt;
- eine Kombination der aus den Dämpfungs- und Filterungsschritten kommenden Signale, die ein kombiniertes analoges Signal ausgibt,

und einen Schritt der Kopplung mit dem Stromnetz, um das kombinierte analoge Signal über Powerline in einem Frequenzband in der Größenordnung von 0 bis 87,5 MHz zu übertragen.

14. Verfahren zum Empfangen eines über Powerline übertragenen analogen Signals, **dadurch gekennzeichnet, dass** es umfasst:

einen Schritt der Kopplung mit dem Stromnetz, um das über Powerline in einem Frequenzband in der Größenordnung von 0 bis 87,5 MHz übertragene analoge Signal zu empfangen,
einen Gewichtungsfilterungsschritt des analogen Signals, ausführend:

- eine Dämpfung des analogen Signals;
- eine Filterung des analogen Signals, die einen Hochpassfilter einsetzt, dessen Grenzfrequenz in der Größenordnung von 30 MHz liegt;
- ein Kombinieren (43) der aus den Dämpfungs- und Filterungsschritten kommenden Signale, die ein kombiniertes analoges Signal ausgibt.

15. Computerprogramm mit Anweisungen zum Ausführen eines Verfahrens nach einem der Ansprüche 13 bis 14, wenn dieses Programm von einem Prozessor abgearbeitet wird.

**Claims**

1. Device for transmitting an analogue signal through power line communication, **characterized in that** it comprises a weighting filter (61) comprising:

   - a first branch (41) comprising attenuation means for attenuating an analogue input signal;
   - a second branch (42) comprising filtering means for filtering said analogue input signal, comprising a low-pass filter whose cutoff frequency is of the order of 30 MHz;
   - combination means (43) for combining the signals from said first and second branches, in order to deliver a combined analogue signal;

   and a module for coupling to the electrical network, for transmitting said combined analogue signal through power line communication in a frequency band of the order of 0 to 87.5 MHz.

2. Transmission device according to Claim 1, **characterized in that** it furthermore comprises:

   - a digital processing module (21) for processing data to be transmitted, at the physical layer, in order to deliver a digital signal;
   - a frequency-time conversion module (22) for converting said digital signal;
   - a digital-to-analogue conversion module (23) for converting said digital signal into the temporal domain, in order to deliver said analogue input signal;
   - an amplification module (24) for amplifying said analogue input signal, and for feeding said weighting filter (61).

3. Transmission device according to Claim 1, **characterized in that** the filtering means of said weighting filter comprise three filtering cells, including two "M cell" cells framing a "constant K cell" cell,
   said M cells each comprising three inductive components and a capacitive component and said constant K cell comprising two inductive components and a capacitive component,
   each of the inductive components of said constant K cell being able to be grouped with an inductive component of one of said M cells.

4. Transmission device according to Claim 1, **characterized in that** said attenuation means comprise a resistance attenuator.

5. Transmission device according to Claim 1, **characterized in that** said combination means comprise a differential amplifier.

6. Transmission device according to Claim 1, **characterized in that** the power of said combined analogue signal complies with a predetermined power profile having a maximum power in a second frequency sub-band 30 dB lower than the maximum power in a first frequency sub-band, the first sub-band being of the order of 0 to 30 MHz and the second sub-band being of the order of 30 to 87.5 MHz.

7. Device for receiving an analogue signal transmitted through power line communication, **characterized in that** it comprises:

   a module for coupling to the electrical network, in order to receive said analogue signal transmitted through power line communication in a frequency band of the order of 0 to 87.5 MHz, and
   a weighting filter (62) comprising:

- a first branch (41) comprising attenuation means for attenuating said analogue signal;
- a second branch (42) comprising filtering means for filtering said signal, comprising a high-pass filter whose cutoff frequency is of the order of 30 MHz;
- combination means (43) for combining the signals from said first and second branches, and for delivering a combined analogue signal.

8. Reception device according to Claim 7, **characterized in that** it furthermore comprises:

- a controlled-gain amplification module (28) for amplifying the combined analogue signal from said weighting filter (62);
- an analogue-to-digital conversion module (29) for converting said amplified analogue signal, and for delivering a digital signal;
- a time-frequency conversion module (22) for converting said digital signal;
- a digital processing module (21) for processing said digital signal in the frequency domain, at the physical layer, and for reconstructing transmitted data.

9. Reception device according to Claim 7, **characterized in that** the filtering means of said weighting filter comprise three filtering cells, including two "M cell" cells framing a "constant K cell" cell,
said M cells each comprising three capacitive components and an inductive component and said constant K cell comprising two capacitive components and an inductive component,
each of the capacitive components of said constant K cell being able to be grouped with a capacitive component of one of said M cells.

10. Reception device according to Claim 7, **characterized in that** said attenuation means comprise a resistance attenuator.

11. Reception device according to Claim 7, **characterized in that** said combination means comprise a differential amplifier.

12. Reception device according to Claim 7, **characterized in that** the power of said analogue signal complies with a predetermined power profile having a maximum power in a second frequency sub-band 30 dB lower than the maximum power in a first frequency sub-band, the first sub-band being of the order of 0 to 30 MHz and the second sub-band being of the order of 30 to 87.5 MHz.

13. Method for transmitting an analogue signal through power line communication, **characterized in that** it comprises a weighting filtering step, implementing:

- attenuation of an analogue input signal;
- filtering of said analogue input signal, implementing a low-pass filter whose cutoff frequency is of the order of 30 MHz;
- combination of the signals from said attenuation and filtering steps, delivering a combined analogue signal

and a step of coupling to the electrical network, in order to transmit said combined analogue signal through power line communication in a frequency band of the order of 0 to 87.5 MHz.

14. Method for receiving an analogue signal transmitted through power line communication, **characterized in that** it comprises
a step of coupling to the electrical network, in order to receive said analogue signal transmitted through power line communication in a frequency band of the order of 0 to 87.5 MHz,
a weighting filtering step on said analogue signal, implementing:

- attenuation of said analogue signal;
- filtering of said analogue signal, implementing a high-pass filter whose cutoff frequency is of the order of 30 MHz;
- combination (43) of the signals from said attenuation and filtering steps, delivering a combined analogue signal.

15. Computer program including instructions for implementing a method according to either one of Claims 13 and 14 when said program is executed by a processor.

**Fig. 1**

**Fig. 2**

**Fig. 3**

**Fig. 4**

**Fig. 5A**

**Fig. 5B**

**Fig. 5C**

**Fig. 6**

**Fig. 7**

$20 \cdot \lg\{|H_k|\}$ — — —

$20 \cdot \lg\{|H_{p_k}|\}$ - - - - -

$20 \cdot \lg\{|T_k|\}$ ———

**Fig.8A**

$\underline{Phi_k}$

**Fig.8B**

$20 \cdot \lg\{|HH_k|\}$ ———

$20 \cdot \lg\{|HH_{p_k}|\}$ - - - - -

$20 \cdot \lg\{|TH_k|\}$ ———

**Fig.9A**

$\underline{PHhi_k}$

**Fig.9B**

$20 \cdot \lg\{|TH_k \cdot T_k|\}$ ———

**Fig.10A**

$\underline{PThi_k}$

$TPG(k)$ - - - - -

**Fig.10B**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009150224 A

- US 20110194626 A

**Littérature non-brevet citée dans la description**

- **STEFANO GALLI ; OLEG LOGVINOV.** Recent Developments in the Standardization of Power Line Communications within the IEEE. *IEEE Communications Magazine,* Juillet 2008